(19) **Europäisches Patentamt**
**European Patent Office**
**Office européen des brevets**

(11) **EP 4 676 078 A1**

(12) **EUROPEAN PATENT APPLICATION**

(43) Date of publication:
**07.01.2026 Bulletin 2026/02**

(21) Application number: **24315327.7**

(22) Date of filing: **04.07.2024**

(51) International Patent Classification (IPC):
**H04N 25/47** (2023.01)   **H04N 25/671** (2023.01)
**H04N 25/707** (2023.01)   **H03K 5/24** (2006.01)

(52) Cooperative Patent Classification (CPC):
**H04N 25/47; H03K 5/24; H04N 25/671;
H04N 25/707**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Prophesee**
**75012 Paris (FR)**

(72) Inventors:
• **HANAJIMA, Naoyuki**
  **Ibaraki (JP)**
• **FINATEU, Thomas**
  **Veneux les sablons (FR)**
• **MATOLIN, Daniel**
  **Freital (DE)**

(74) Representative: **de Jong, Jean Jacques et al**
**Omnipat**
**610 Chemin de Fabrègues**
**13510 Éguilles (FR)**

(54) **IMPROVEMENT OF CONTRAST SENSITIVITY IN EVENT-BASED SENSORS BY COMPARATOR OFFSET CANCELLATION**

(57)    A comparator circuit for detecting an amount of variation in an input signal (Vlog) is provided, comprising a comparator having a non-inverting input (Vref_pos, Vref_neg) and an inverting input (Vcp, Vcn); a capacitor (Cp, Cn) connected between the inverting input and a terminal for applying the input signal as a voltage (Vlog); a reset switch (SWrp, SWrn) connected between the inverting input and an output (EPOS, ENEG) of the comparator; and a calibration switch (SWcp, SWcn) connected to select for the non-inverting input a voltage among a threshold voltage (Vth_pos, Vth_neg) and a calibration voltage (Vcal_pos, Vcal_neg).

Fig 3

**Description**

**Technical Field**

The present disclosure relates to pixel circuits of event-based vision sensors, and more particularly to the comparators used in such circuits.

**Background**

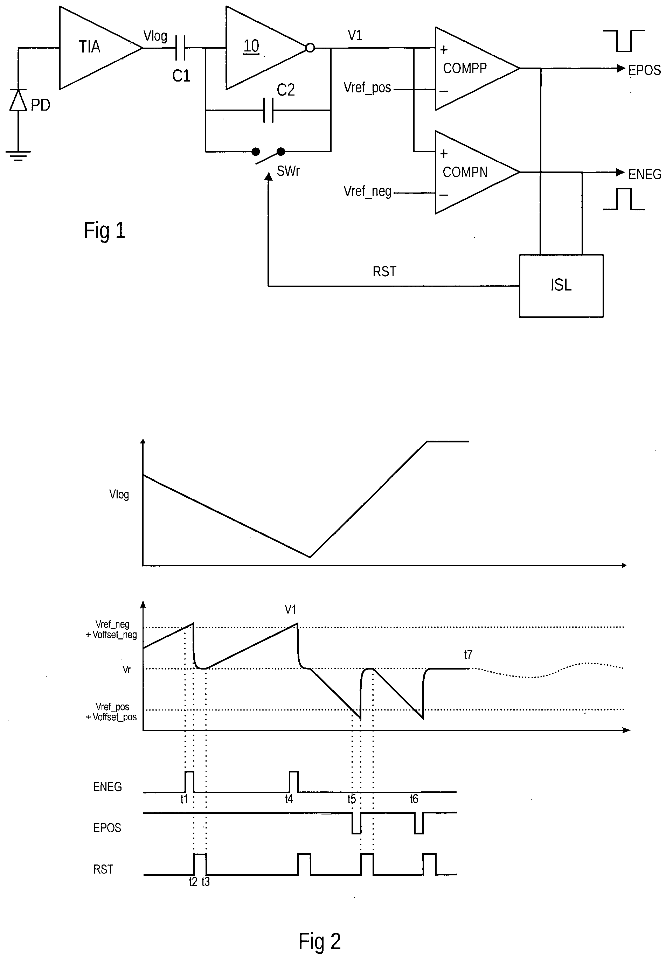

Figure 1 is a schematic diagram of a conventional signal processing circuit of a pixel of an event-based vision sensor, such as disclosed, for instance in patent US11375149. The pixel includes a photodiode PD that pulls a photocurrent from its cathode to ground. The photocurrent, representing a level of illumination; is converted to a voltage Vlog by a logarithmic transimpedance amplifier TIA. Voltage Vlog is applied to an inverter 10 through a capacitor C1. The output of the inverter produces a voltage V1 and is fed-back to the input through a capacitor C2. A reset switch SWr is connected across capacitor C2.

Voltage V1 is applied to non-inverting inputs of two comparators COMPP and COMPN. Comparators COMPP and COMPN receive respective DC reference voltages Vref_pos and Vref_neg on their inverting inputs. The output of comparator COMPP serves as a positive event indicator EPOS that is active low, whereas the output of comparator COMPN serves as a negative event indicator ENEG that is active high.

The event indicators EPOS and ENEG are provided to an interface and state logic circuit ISL that implements event management functionality and provides a reset signal RST for the switch SWr.

Such a comparator structure is prone to offsets in the thresholds at which the EPOS and ENEG signals are triggered. These offsets may also vary between the pixels of a same image sensor array. The offsets become detrimental when seeking a higher sensitivity to illumination changes.

**Summary**

A comparator circuit is generally provided for detecting an amount of variation in an input signal, the circuit comprising a comparator having a non-inverting input and an inverting input; a capacitor connected between the inverting input and a terminal for applying the input signal as a voltage; a reset switch connected between the inverting input and an output of the comparator; and a calibration switch connected to select for the non-inverting input a voltage among a threshold voltage and a calibration voltage.

The comparator circuit may further comprise a control circuit configured to operate the switches according to the following modes: a normal mode where the reset switch is open, and the calibration switch selects the threshold voltage for the non-inverting input of the comparator; and a calibration mode started after the voltage on the inverting input has crossed the threshold voltage on the non-inverting input, where the reset switch is closed, and the calibration switch selects the calibration voltage for the non-inverting input.

The control circuit may be further configured to issue a row read-out request signal to peripheral circuitry when the voltage on the inverting input has crossed the threshold voltage on the non-inverting input; and start the calibration mode when a row read-out acknowledge signal is received from the peripheral circuitry.

The control circuit may be further configured to start the calibration mode and issue a row read-out request signal to peripheral circuitry when the voltage on the inverting input has crossed the threshold voltage on the non-inverting input.

The control circuit may be further configured to end the calibration mode during an active state of a row read-out acknowledge signal received from the peripheral circuitry.

The control circuit may be configured, during the calibration mode, to open the reset switch before the end of the calibration mode.

The comparator circuit may be supplied between a first and a second power supply level, and the calibration voltage may be set closer to the first power supply level than to the second power supply level, and the threshold voltage may be set between the calibration voltage and the second power supply level.

A pixel circuit of an event-based vision sensor may comprise a comparator circuit as defined above; a photodiode; and an amplifier having an input connected to the photodiode and an output connected to the terminal for applying the input signal of the comparator circuit.

A symmetrical comparator circuit is generally provided for detecting an amount of variation in an input signal, the circuit comprising first and second comparators having each a non-inverting input and an inverting input; first and second capacitors connected between the inverting input of a respective one of the comparators and a terminal for applying the input signal as a voltage; first and second reset switches connected between the inverting input and an output of a respective one of the comparators; and first and second calibration switches connected to select for the non-inverting input of a respective one of the comparators a voltage among a respective threshold voltage and a respective calibration voltage, wherein each calibration voltage has a level comprised between the threshold voltages.

**Brief Description of the** Drawings

Embodiments will be exposed in the following description provided for exemplary purposes only, in relation to the appended drawings, in which:

Figure 1 is a schematic diagram of a conventional event-based pixel circuit;

Figure 2 is a time diagram illustrating an exemplary operation of the pixel circuit of figure 1;

Figure 3 is a schematic diagram of an embodiment of an event-based pixel circuit implementing offset compensation; and

Figure 4 is a time diagram illustrating an exemplary operation of the circuit of figure 3.

Figure 5 is a time diagram illustrating an alternative operation of the circuit of figure 3.

**Detailed Description**

Considering the inverter circuit of figure 1 in more detail, capacitor C1 acts as a sample-and-hold capacitor controlled by switch SWr, whereas capacitor C2 sets an AC gain of the inverter to -C1/C2. When switch SWr is open, the variation of voltage Vlog with respect to a value held in the capacitor C1 is amplified and inverted to form voltage V1.

When switch SWr is closed, the inverter is reset by assuming an equilibrium where its output and input voltages become equal to a DC rest voltage Vr inherent to the structure of the inverter. Capacitor C1 is thus "reset" to hold the voltage differential Vlog - Vr while the voltage across capacitor C2 is zeroed.

The inverter is typically a CMOS inverter including a pair of NMOS and PMOS transistors. The rest voltage Vr then lies somewhere between the power supply levels Vdd and GND of the inverter, depending on the relative sizes of the transistors. The amounts of variation of voltage Vlog that trigger the EPOS and ENEG signals are (Vref_pos - Vr) and (Vref_neg - Vr), where Vref_pos and Vref_neg are the comparator reference voltages. These values are referred to as the "detection thresholds" for the positive and negative events, and they are preferably equal, whereby voltages Vref_pos and Vref_neg are typically chosen so that an expected value for Vr lies halfway between them.

An exemplary detection threshold may be around 50 mV. In a pixel circuit operating at 1.0 V, Vr may be about. 0.5 V, whereby Vref_pos and Vref_neg would be around 0.45 and 0.55 V.

Figure 2 better illustrates the operation of the circuit of figure 1 with an exemplary variation of voltage Vlog, shown in the first graph. Voltage Vlog first decreases linearly, then increases linearly at a faster rate. The remaining graphs show the corresponding variations of voltage V1 at the output of the inverter, comparator signals EPOS and ENEG, and the reset signal RST. The gain of the inverter is assumed to be -1, for illustrative purposes, with C1 = C2. The rest voltage Vr is assumed to be halfway between the reference voltages Vref_pos and Vref_neg. Vref_neg is the higher of the reference voltages because voltage V1 is an inverted representation of Vlog.

Voltage V1, inversely tracking voltage Vlog, starts by increasing from a previous state held in capacitor C1, say between Vr and Vref_neg. At a time t1, voltage V1 crosses reference voltage Vref_neg, causing signal ENEG to become active high, indicating the occurrence of a negative event (or "off" or "down" event). In practice, comparator COMPN is prone to internal component mismatches, which result in an offset illustrated by a signed voltage Voffset_neg added to the reference voltage Vref_neg, so signal ENEG is triggered in practice when voltage V1 crosses Vref_neg + Voffset_neg.

As soon as the event is handled by the imager control circuitry at a time t2, the interface and state logic circuit ISL enables the reset signal RST. This forces the inverter to assume its rest state, where the input of the inverter and voltage V1 are forced to the rest voltage Vr. Capacitor C1 then stores the difference Vlog - Vr.

At a time t3, sufficient for voltage V1 to reach voltage Vr, the reset signal RST is disabled by circuit ISL. Voltage V1 then starts tracking voltage Vlog again, starting from voltage Vr.

At a time t4, voltage V1 again crosses reference voltage Vref_neg (plus offset), causing the same behavior as at times t1 to t3. In the meantime, signal Vlog starts its increase, so when the reset signal RST is disabled again, voltage V1 starts a corresponding decrease from voltage Vr.

At a time t5, voltage V1 crosses reference voltage Vref_pos, causing signal EPOS to become active low, indicating the occurrence of a positive event (or "on" or "up" event). A similar reset sequence occurs as at times t1 to t3, after which voltage V1 starts tracking voltage Vlog again, by decreasing from voltage Vr. In practice, like for comparator COMPN, comparator COMPP is subject to an offset illustrated by a signed voltage Voffset_pos added to the reference voltage Vref_pos, so signal EPOS is triggered in practice when voltage V1 crosses Vref_pos + Voffset_pos.

At a time t6, voltage V1 reaches voltage Vref_pos (plus offset) again, causing the same sequence of events as at time t5.

The comparators COMPP, COMPN are in practice of the simplest possible structure to save surface area and power consumption. Their offsets result from fabrication mismatches, in particular transistor sizes, so they vary from pixel to pixel. The two closely located comparators of a same pixel are likely to have similar offset values, but this is not guaranteed for all pixels. In the likely situation where the offsets of the two comparators of a pixel have at least the same sign, there is an asymmetry between the positive and negative detection thresholds by the average of the two offsets, assuming voltages Vref_pos and Vref_neg have been set at their desired values without considering the offsets.

Moreover, as shown from a time t7, the rest voltage Vr is illustrated as varying. As previously mentioned, the voltage Vr is inherent to the inverter structure, and typically depends on the relative sizes of transistors forming the inverter. The transistors of the inverter are usually the smallest available in the technology to save surface area, in which case the smallest size differences due to manufacturing tolerances have a greater impact, to such an extent that the rest voltages vary among pixels of a same sensor array.

The different rest voltages Vr thus also create asymmetric positive and negative detection thresholds.

A comparator structure is provided in the following, wherein the detection thresholds remain symmetric and substantially constant over the pixel array.

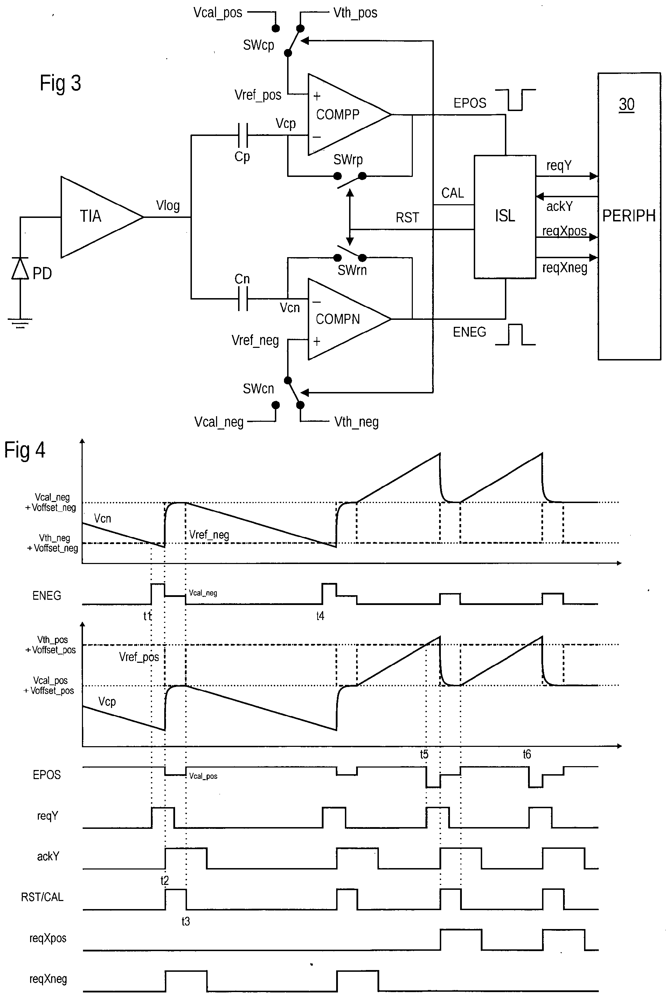

Figure 3 is a schematic diagram of an embodiment of an event-based pixel circuit achieving such an objective. The circuit is structured around two comparators COMPP and COMPN and omits the inverter sample-and-hold structure of figure 1. The inverting inputs of the comparators receive the voltage Vlog produced by the transimpedance amplifier TIA through respective capacitors Cp and Cn. A respective reset switch SWrp, SWrn for each comparator is connected between the output of the comparator and the inverting input.

The capacitors Cp, Cn and switches SWrp, SWrn reproduce the sample-and-hold functionality that was implemented in figure 1 around the inverter. However, with the present structure implemented around each comparator, when the reset switches are closed, the comparators are connected as operational amplifiers in unity gain mode. The comparators then copy on their outputs the voltages present on their non-inverting inputs, which can be set to any desired value.

Thus, a calibration switch SWcp is connected to the non-inverting input of comparator COMPP to apply a voltage Vref_pos selectable among a DC calibration voltage Vcal_pos and a DC threshold voltage Vth_pos. Similarly, a calibration switch SWcn is connected to the non-inverting input of comparator COMPN to apply a voltage Vref_neg selectable among a DC calibration voltage Vcal_neg and a DC threshold voltage Vth_neg.

Like in figure 1, the comparators provide positive and negative event detection signals EPOS, ENEG to an interface and state logic circuit ISL. Signal EPOS is active low, while signal ENEG is active high. Circuit ISL controls the reset switches SWrp, SWrn through a single reset signal RST, and controls the calibration switches SWcp, SWcn through a single calibration signal CAL. Switches SWrp and SWrn are closed when signal RST is active. When signal CAL is active, switches SWcp and SWcn select the calibration voltages Vcal_pos and Vcal_neg for the comparators, otherwise they select the threshold voltages Vth_pos and Vth_neg.

Moreover, circuit ISL is configured to implement an event read-out protocol with peripheral circuitry 30. To this end, circuit ISL produces a row read-out request signal reqY for the peripheral circuitry and receives a row read-out acknowledge signal ackY from the peripheral circuitry. Circuit ISL further shapes signals EPOS and ENEG into signals reqXpos and reqXneg adapted to specifications of the peripheral circuitry.

In practice, signals RST and CAL may be the same signal. Voltages Vcal_pos, Vcal_neg, Vth_pos and Vth_neg are set externally for the whole sensor array by circuitry capable of maintaining them stable and at accurate values. Voltages Vcal_pos and Vcal_neg, as will be shown below, play the role of the rest voltage Vr of figure 1, while being common to all pixels and independent of transistor sizing. Voltages Vcal_pos and Vcal_neg may be equal.

Figure 4 is a time diagram illustrating an exemplary operation of the circuit of figure 3, with the same exemplary variation of voltage Vlog. Two separate graphs show the evolutions, in solid lines, of the voltages Vcp and Vcn at the inverting inputs of comparators COMPP and COMPN, with the corresponding evolutions, in dotted lines, of the voltages Vref_pos, Vref_neg at the non-inverting inputs of the comparators. Signals RST and CAL are shown as identical. Here, voltages Vcp and Vcn are not inverted with respect to voltage Vlog, so they track voltage Vlog with the same sign.

Initially, reset switches SWrp, SWrn are open, while the calibration switches SWcp, SWcn select the threshold voltages Vth_pos, Vth_neg. Voltages Vcn and Vcp vary similarly, except that they may be offset by the difference between the calibration voltages Vcal_pos, Vacl_neg. Each voltage Vcp, Vcn starts at an initial value stored in the respective capacitor Cp, Cn, for instance below the respective calibration voltage. The capacitors Cp, Cn having no discharge path, each voltage Vcp, Vcn simply follows voltage Vlog with an offset stored in the respective capacitor.

At a time t1, voltage Vcn crosses voltage Vref_neg that, considering the offset of the comparator, is equal to Vth_neg + Voffset_neg, causing signal ENEG to become active high, indicating the occurrence of a negative event. The row read-out request signal reqY, configured to become active with any of signals EPOS and ENEG, becomes active at time t1. Signal reqY may be common to a row of pixels, so it may already have been activated by another pixel of the same row.

In the meantime, voltage Vcp has pulled away from voltage Vref_pos.

At a time t2, in response to the request signal reqY, the peripheral circuitry, when ready, activates the corresponding acknowledge signal ackY during a system clock period. In response to the edge of signal ackY, the circuit ISL enables the reset and calibration signals RST, CAL. This switches the non-inverting inputs of the comparators to their respective calibration voltages Vcal_pos, Vcal_neg. The comparators then being configured in unity gain, their outputs EPOS, ENEG copy voltages Vcal_pos, Vcal_neg and apply them at low impedance to the inverting inputs, involving their respective offsets. Voltages Vcp, Vcn at these inputs are thus forced to voltages Vcal_pos + Voffset_pos, Vcal_neg + Voffset_neg against capacitors Cp, Cn. Capacitors Cp and Cn then hold new voltage states (Vlog - Vcal_pos - Voffset_pos) and (Vlog - Vcal_neg - Voffset_neg) until a new reset phase.

Signal reqXneg, representing signal ENEG, is also activated at time t2. Signal reqXneg stays active during a system clock period to indicate the polarity (negative) of the event for read-out.

Signal reqY is disabled by circuit ISL after the acknowledge signal ackY is taken into account, i.e. after the reset phase is initiated.

As shown, during the reset phase, both signals EPOS and ENEG temporarily assume a calibration state between logic levels low and high, equal to the respective calibration voltage plus offset. These transient states have no consequence, since the effective polarity used for read-out is conveyed by signals reqXpos, reqXneg, whose state is set before entering the reset phase and is maintained during the reset phase.

With this configuration, the positive detection threshold is expressed as:

$$(Vth\_pos + Voffset\_pos) - (Vcal\_pos + Voffset\_pos) = Vth\_pos - Vcal\_pos.$$

The negative detection threshold is expressed as:

$$(Vth\_neg + Voffset\_neg) - (Vcal\_neg + Voffset\_neg) = Vth\_neg - Vcal\_neg.$$

In other words, the comparator offsets are cancelled-out and the detection thresholds depend only on voltages that are set externally with the desired accuracy and stability.

At a time t3, sufficient for voltages Vcp, Vcn to reach the calibration voltages plus offsets, the reset and calibration signals RST, CAL are disabled by circuit ISL. Voltages Vcp, Vcn are then freed by switches SWrp, SWrn to track voltage Vlog again, starting from the respective calibration voltages plus the offsets stored in the capacitors Cp, Cn. At the same time, the non-inverting inputs are switched back to the threshold voltages Vth_pos, Vth_neg.

If the reset and calibration signals are distinct, the calibration signal may be activated at the same time as the reset signal, but deactivated slightly after the reset signal. This ensures that the calibration voltages are still applied to the capacitors Cp, Cn at the end of the reset phase. While the calibration signal is still active after the reset signal, the inputs of the comparators start at equal voltages, that put the comparators in uncertain states. In particular, a comparator may trigger its detection signal EPOS, ENEG again. The logic in circuit ISL may be configured to ignore such spurious detection signals while the calibration signal is active.

At a time t4, voltage Vcn again crosses Vref_neg = Vth_neg + Voffset_neg, causing the same behavior as at times t1 to t3. In the meantime, signal Vlog starts varying in opposite direction, so when the reset signal RST is disabled again, voltages Vcp, Vcn start a corresponding increase from voltages Vcal_pos + Voffset_pos, Vcal_neg + Voffset_neg.

At a time t5, voltage Vcn reaches reference voltage Vref_pos = Vth_pos + Voffset_pos, causing signal EPOS to become active low, and signal reqXpos to be activated, indicating the occurrence of a positive event. A similar reset and calibration sequence occurs as at times t1 to t3, after which voltages Vcp, Vcn start tracking voltage Vlog again, by increasing from voltages Vcal_pos + Voffset_pos, Vcal_neg + Voffset_neg.

At a time t6, voltage Vcn reaches voltage Vth_pos + Voffset_pos again, causing the same sequence of events as at time t5.

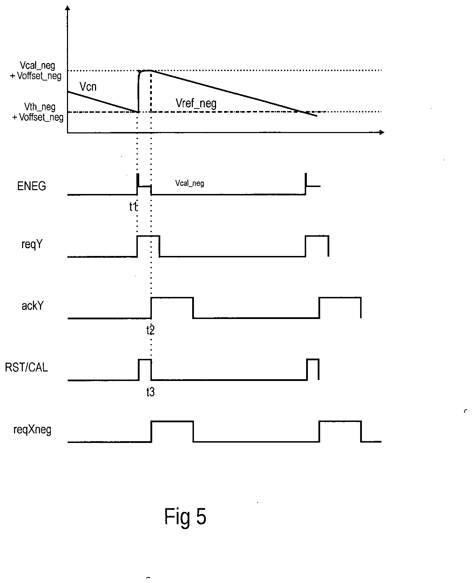

Figure 5 is a partial time diagram illustrating an alternative operation of the circuit of figure 3. In Figure 4, it was assumed that the reset and calibration phases RST/CAL started upon reception of the acknowledgement signal ackY. According to the shown alternative, the reset and calibration phases start at time t1 when any of signals ENEG, EPOS becomes active.

If it was not already active, request signal reqY becomes active at time t1 similarly as in figure 4 and is disabled in response to signal ackY becoming active at time t2.

Signal RST/CAL may be disabled, as shown, by signal ackY becoming active at time t2, whereby times t2 and t3 are merged. In situations where signal ackY may be received too soon after signal reqY, causing signal RST/CAL to not be active long enough for its intended purpose, circuit ISL may be configured to ensure signal RST/CAL has a minimum duration, for instance of one system clock period. In that case, signal RST/CAL would disable during the interval while signal ackY is active, or afterwards.

As shown at time t1, signal ENEG presents a short pulse, sufficiently long for circuit ISL to detect it and cause signal RST/CAL to become active in response.

This alternative has the advantage of reducing the idle phase between the threshold detection t1 and the reset/calibration release t3, and thus allows to capture a larger proportion of events in a given time interval.

In the structure of figure 3, the calibration voltages Vcal_pos and Vcal_neg may be individually set at different values. In most applications, they will be equal to half the circuit's supply voltage, i.e. Vdd/2. In applications where high detection thresholds are desired, for instance greater than Vdd/2, the calibration voltages may be set asymmetrically, with Vcal_pos closer to GND and Vcal_neg closer to Vdd.

The structure of figure 3 does not have an intermediate amplifier like in figure 1. If the gain of the transimpedance amplifier TIA is insufficient, an amplifier may be inserted after it.

Although the comparator circuit has been described in relation with an event-based vision sensor, it is applicable more broadly to situations where amounts of variation in any signal need to be detected.

## Claims

1. A comparator circuit for detecting an amount of variation in an input signal (Vlog), the circuit comprising:

   a comparator having a non-inverting input (Vref_pos, Vref_neg) and an inverting input (Vcp, Vcn);
   a capacitor (Cp, Cn) connected between the inverting input and a terminal for applying the input signal as a voltage (Vlog);
   a reset switch (SWrp, SWrn) connected between the inverting input and an output (EPOS, ENEG) of the comparator; and
   a calibration switch (SWcp, SWcn) connected to select for the non-inverting input a voltage among a threshold voltage (Vth_pos, Vth_neg) and a calibration voltage (Vcal_pos, Vcal_neg).

2. The circuit of claim 1, comprising a control circuit (ISL) configured to operate the switches according to the following modes:

   a normal mode where the reset switch (SWrp) is open, and the calibration switch (SWcp) selects the threshold voltage (Vth_pos) for the non-inverting input of the comparator; and
   a calibration mode started after the voltage on the inverting input has crossed the threshold voltage (Vth_pos) on the non-inverting input, where the reset switch is closed, and the calibration switch selects the calibration voltage (Vcal_pos) for the non-inverting input.

3. The circuit of claim 2, wherein the control circuit (ISL) is further configured to:

   issue a row read-out request signal (reqY) to peripheral circuitry (30) when the voltage on the inverting input has crossed the threshold voltage (Vth_pos) on the non-inverting input; and
   start the calibration mode when a row read-out acknowledge signal (ackY) is received from the peripheral circuitry.

4. The circuit of claim 2, wherein the control circuit (ISL) is further configured to:
   start the calibration mode and issue a row read-out request signal (reqY) to peripheral circuitry (30) when the voltage on the inverting input has crossed the threshold voltage (Vth_pos) on the non-inverting input.

5. The circuit of claim 4, wherein the control circuit (ISL) is further configured to:
   end the calibration mode during an active state of a row read-out acknowledge signal (ackY) received from the peripheral circuitry.

6. The circuit of claim 2, wherein the control circuit is configured, during the calibration mode, to open the reset switch before the end of the calibration mode.

7. The circuit of claim 1, supplied between a first and a second power supply level (GND, Vdd), wherein the calibration voltage (Vcal_pos) is set closer to the first power supply level (GND) than to the second power supply level (Vdd), and the threshold voltage (Vth_pos) is set between the calibration voltage and the second power supply level (Vdd).

8. A pixel circuit of an event-based vision sensor, comprising:

   a comparator circuit according to claim 1;
   a photodiode (PD); and
   an amplifier having an input connected to the photodiode and an output connected to the terminal for applying the input signal of the comparator circuit.

9. A comparator circuit for detecting an amount of variation in an input signal (Vlog), the circuit comprising:

   first and second comparators having each a non-inverting input (Vref_pos, Vref_neg) and an inverting input (Vcp, Vcn);
   first and second capacitors (Cp, Cn) connected between the inverting input of a respective one of the comparators and a terminal for applying the input signal as a voltage (Vlog);
   first and second reset switches (SWrp, SWrn) connected between the inverting input and an output (EPOS, ENEG) of a respective one of the comparators; and first and second calibration switches (SWcp, SWcn) connected to select for the non-inverting input of a respective one of the comparators a voltage among a respective threshold voltage (Vth_pos, Vth_neg) and a respective calibration voltage (Vcal_pos, Vcal_neg), wherein each calibration voltage has a level comprised between the threshold voltages.

Fig 1

Fig 2

**Fig 3**

Vcal_pos — Vth_pos
SWcp

Vref_pos
+ COMPP −
Vcp
Cp
EPOS

TIA Vlog
PD

SWrp
CAL
RST
ISL
PERIPH 30

reqY
ackY
reqXpos
reqXneg

Cn
Vcn
SWrn
COMPN − +
Vref_neg
ENEG

SWcn
Vcal_neg — Vth_neg

**Fig 4**

Vcal_neg + Voffset_neg
Vcn
Vth_neg + Voffset_neg
Vref_neg

ENEG
Vcal_neg
tt t4

Vth_pos + Voffset_pos
Vref_pos
Vcal_pos + Voffset_pos
Vcp
t5 t6

EPOS
Vcal_pos

reqY

ackY

RST/CAL
t2
t3

reqXpos

reqXneg

Fig 5

Europäisches
Patentamt

European
Patent Office

Office européen
des brevets

# EUROPEAN SEARCH REPORT

**Application Number**

EP 24 31 5327

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/345645 A1 (NIWA ATSUMI [JP] ET AL) 27 October 2022 (2022-10-27) | 1,2,8,9 | INV.<br>H04N25/47<br>H04N25/671<br>H04N25/707<br>H03K5/24 |
| Y | * paragraphs [0206] - [0227]; figures 24,25 * | 1-9 | |
| X | US 2016/274643 A1 (LIU HONGJIE [CH] ET AL) 22 September 2016 (2016-09-22) | 1,2,8 | |
| Y | * paragraphs [0060] - [0069], [0076] - [0084]; figure 6 *<br>* paragraphs [0087] - [0097]; figure 8A * | 1-9 | |
| Y | US 2023/247316 A1 (TANAKA TERUKAZU [JP] ET AL) 3 August 2023 (2023-08-03)<br>* paragraphs [0056] - [0061], [0071] - [0084]; figures 2,6-8 * | 1-9 | |

**TECHNICAL FIELDS SEARCHED (IPC)**

H04N

The present search report has been drawn up for all claims

| Place of search | Date of completion of the search | Examiner |
|---|---|---|
| Munich | 5 November 2024 | Moorhouse, David |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 24 31 5327

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2024

| Patent document cited in search report | | Publication date | Patent family member(s) | | Publication date |
|---|---|---|---|---|---|
| US 2022345645 | A1 | 27-10-2022 | JP | 2021048554 A | 25-03-2021 |
| | | | US | 2022345645 A1 | 27-10-2022 |
| | | | WO | 2021053946 A1 | 25-03-2021 |
| US 2016274643 | A1 | 22-09-2016 | KR | 20160112219 A | 28-09-2016 |
| | | | US | 2016274643 A1 | 22-09-2016 |
| US 2023247316 | A1 | 03-08-2023 | US | 2023247316 A1 | 03-08-2023 |
| | | | WO | 2022009720 A1 | 13-01-2022 |

EPO FORM P0459

For more details about this annex : see Official Journal of the European Patent Office, No. 12/82

**REFERENCES CITED IN THE DESCRIPTION**

**Patent documents cited in the description**

- US 11375149 B